Europäisches Patentamt

European Patent Office

Office européen des brevets

(19)

(11) Veröffentlichungsnummer: **0 324 089**
**A2**

# EUROPÄISCHE PATENTANMELDUNG

(21) Anmeldenummer: 88119717.2

(22) Anmeldetag: 25.11.88

(51) Int. Cl.⁴: **H02M 1/08**

(30) Priorität: **11.01.88 DE 3800511**

(43) Veröffentlichungstag der Anmeldung:
**19.07.89 Patentblatt 89/29**

(84) Benannte Vertragsstaaten:
**AT BE CH DE ES FR GB GR IT LI LU NL SE**

(71) Anmelder: **Nixdorf Computer Aktiengesellschaft Fürstenallee 7 D-4790 Paderborn(DE)**

(72) Erfinder: **Pollmeier, Werner Mozartweg 8 D-4837 Verl 1(DE)**
Erfinder: **Götz, Manfred Heinefelder Weg 59 D-3492 Brakel(DE)**

(74) Vertreter: **Schaumburg, Thoenes & Englaender Mauerkircherstrasse 31 Postfach 86 07 48 D-8000 München 80(DE)**

(54) Verfahren zum Erzeugen von Spannungsimpulsen.

(57) Die Erfindung betrifft ein Verfahren zum Erzeugen von Spannungsimpulsen zur Steuerung des Schaltbetriebes in Schaltnetzteilen. Ein Spannungsanstieg eines Impulsgenerators wird jeweils bei Erreichen eines ersten, unteren Schwellwertes (A) gestartet. Das Rücksetzen des Spannungsanstieges erfolgt im freilaufenden Betrieb, wenn der Spannungsanstieg einen zweiten (D) oder einen dritten (C), zwischen dem ersten (A) und zweiten (D) liegenden Schwellwert erreicht. Im Synchronisationsbetrieb veranlassen die im Synchronisationssignal ($V_{sync}$) auftretenden Impulsflanken das Rücksetzen des Spannungsanstieges. Die Vorteile der Erfindung liegen darin, daß der beim Übergang vom freilaufenden Betrieb in den Synchronisationsbetrieb infolge des Frequenzunterschiedes auftretende Schaltstrom minimal wird und der Generator zuverlässig arbeitet.

Fig. 1

## Verfahren zum Erzeugen von Spannungsimpulsen

Die Erfindung betrifft ein Verfahren zum Erzeugen von Spannungsimpulsen zur Steuerung des Schaltbetriebes in Schaltnetzteilen, bei dem ein jeweils von einem ersten, unteren Schwellwert ausgehender Spannungsanstieg bei Erreichen eines zweiten, höheren Schwellwertes oder bei Auftreten eines Synchronisationssignales auf den Anfangswert rückgesetzt wird.

Es ist aus der technischen Information 770 415 der Firma Valvo bereits bekannt, in einer Steuer- und Regelschaltung TDA 1060 ein Verfahren zum Erzeugen einer Sägezahnspannung mit einem Impulsgenerator zum Ansteuern des primärseitigen Schalttransistors geregelter Schaltnetzteile einzusetzen. Diese Sägezahnspannung wird dann einem Impulsdauermodulator zugeführt, der die Einschaltdauer des Schalttransistors und somit die dem Netz entnommene Energie variiert. Im Sekundärkreis des Schaltnetzteils wird eine Spannung induziert, die gleichgerichtet und geglättet wird und die Ausgangsspannung des Schaltnetzteils darstellt. Diese wird mit einer internen Referenzspannung verglichen und bei Abweichungen von diesem Sollwert mit der Steuer- und Regelschaltung und über die Einschaltdauer des Schalttransistors nachgeregelt.

Der Sägezahngenerator des Schaltkreises TDA 1060 besteht aus einer Stromquelle sowie einem Transistor, über den ein Kondensator abwechselnd geladen und entladen wird. Am Kondensator treten dann Spannungsimpulse mit Sägezahnform auf.

Zur Verwendung von Schaltnetzteilen zur Speisung von Geräten, die mit Bildschirmen ausgestattet sind, ist es erforderlich, die Schaltfrequenz mit der Zeilenablenkfrequenz des Bildschirmgerätes zu synchronisieren. Weichen diese beiden Frequenzen voneinander ab, so können infolge einer Überlagerung dieser Frequenzen Bildschirmstörungen wie z. B. durchlaufende Streifen auftreten. Es sind deshalb zwei Betriebsarten des Sägezahnimpulsgenerators üblich, der die Erzeugung der Schaltimpulse steuert. Beim freilaufenden Betrieb schwingt der Generator mit einer voreingestellten Nennfrequenz. Der Entladevorgang des Kondensators und damit das Rücksetzen des Spannungsanstieges wird hier beim Überschreiten eines bestimmten oberen Spannungswertes durch eine Schwellwertschaltung ausgelöst. In der anderen Betriebsart, dem Synchronisationsbetrieb, wird die Frequenz des Generators von einem von außen zugeführten Synchronisationssignal vorgegeben. Welcher Betriebszustand sich jeweils einstellt, ist abhängig von dem Vorhandensein des Synchronisationssignales am Synchronisationseingang des Generators. Bleibt der Synchronisationseingang unbeschaltet, so stellt sich selbsttätig der freilaufende Betrieb ein. Wird dem Generator jedoch ein Synchronisationssignal eines definierten Spannungspegels zugeführt, geht dieser in den Synchronisationsbetrieb über.

Beim bekannten Schaltkreis erfolgt die Synchronisation, indem das Synchronisationssignal an den Ausgang der genannten oberen Schwellwertschaltung gelegt wird und so der Entladevorgang bei positivem Signalpegel des Synchronisationssignals gestartet wird. Nachteilig bei diesem Verfahren ist, daß nur Synchronisationsfrequenzen zugelassen sind, die nied riger als die Nennfrequenz des Generators sind. Höhere Frequenzen können von der Schaltung nicht verarbeitet werden. Dies hat zur Folge, daß die Nennfrequenz $f_N$ auf einen Wert einzustellen ist, der deutlich höher ist als die Synchronisationsfrequenz $f_{sync}$. Der sich aus der Differenz von Nennfrequenz und Synchronisationsfrequenz ergebende Frequenzunterschied muß unter normalen Betriebsbedingungen mindestens so groß gewählt werden, daß auch bei einer Schwankung der beiden Frequenzen infolge von Temperatureinfluß oder Alterung die Bedingung $f_N > f_{sync}$ immer eingehalten wird. Dieser Frequenzunterschied ist beim Übergang vom freilaufenden Betrieb in den Synchronisationsbetrieb zu überwinden und führt im Sekundärkreis des Schaltnetzteils zu. einem vorübergehenden Absinken der Ausgangsspannung von dem Sollwert proportional dem Frequenzunterschied. Die Steuer- und Regelschaltung wirkt dem Spannungsrückgang durch Zuführen von mehr Energie aus dem Netz durch Erhöhung des Stromes entgegen. Dadurch kann aber ein unzulässig hoher Strom im Schaltnetzteil fließen, und dieses kann kurzzeitig abschalten. Das Schaltnetzteil muß entsprechend diesem ungünstigen Betriebszustand ausgelegt und damit überdimensioniert werden. Dieser Nachteil ließe sich vermeiden, wenn der Frequenzunterschied zwischen Nennfrequenz und Synchronisationsfrequenz möglichst klein wäre.

Ein weiterer Nachteil des bekannten Verfahrens zur Synchronisation besteht darin, daß ein sicherer Betrieb nur bei definierten Spannungspegeln des Synchronisationssignals gewährleistet ist. So wird ein Starten des Generators erst bei einem Spannungpegel ≧ 2 Volt erreicht. Im allgemeinen wird auch der das Synchronisationssignal erzeugende Schaltungsteil aus dem Schaltnetzteil gespeist, wobei aber sofort nach Einschalten des Gerätes die geforderten Spannungspegel des Synchronisationssignals noch nicht vorliegen. Der Generator kann dann noch nicht anschwingen. Um diesen undefinierten Betriebszustand zu vermeiden, ist es üblich, das Synchronisationssignal für eine kurze Zeit nach dem Einschalten vom Generator abzukoppeln, bis es den erforderlichen Spannungspegel erreicht hat. Das Abkoppeln bewirkt, daß der Generator im freilaufenden Betrieb selbsttätig anschwingt und er erst später durch das Zuschalten des Synchronisationssignals in den Synchronisationsbetrieb überführt wird. Hierfür ist eine spezielle, aufwendige Elektronikschaltung erforderlich, die dann entfallen könnte, wenn der Generator an seinem Synchronisationseingang beliebige Spannungspegel verarbeiten könnte.

Es ist Aufgabe der Erfindung, ein Verfahren und eine Schaltungsanordnung zum Erzeugen von Spannungsimpulsen anzugeben, wodurch die beschriebenen Nachteile beseitigt werden. Im Synchronisationsbetrieb soll der beim Übergang vom freilaufenden Betrieb in den Synchronisationsbetrieb auftretende Frequenzunterschied zwischen Nennfrequenz des Generators und Synchronisationsfrequenz verringert sein, so daß nur kleine Schaltströme fließen, und das Netzteil zuverlässig arbeitet und für eine vorgegebene Nennleistung kleiner als bisher dimensioniert werden kann. Weiterhin soll die Zuverlässigkeit des Schaltnetzteils dadurch erhöht werden, daß der Generator auch dann schwingt, wenn im Synchronisationssignal undefinierte Signalpegel enthalten sind.

Ein Verfahren eingangs genannter Art ist zur Lösung dieser Aufgabe erfindungsgemäß derart ausgebildet, daß der Spannungsanstieg bei Erreichen eines dritten, zwischen dem ersten und dem zweiten liegenden Schwellwertes rückgesetzt wird, wobei dieser Schwellwert bei Fehlen eines Synchronisationssignals oder nach Erreichen des zweiten Schwellwertes wirksam ist, und daß zum Rücksetzen des Spannungsanstieges in dem Synchronisationssignal auftretende Impulsflanken ausgenutzt werden.

Wenn in dieser Weise vorgegangen wird, so stellt sich beim Fehlen eines Synchronisationssignals selbsttätig der freilaufende Betrieb ein. Der Spannungsanstieg erfolgt dann zwischen dem ersten und dem dritten Schwellwert. Letzterer bewirkt das Rücksetzen des Spannungsanstieges auf den Spannungswert des ersten Schwellwertes, und ein neuer Impulszyklus beginnt. Die Nennfrequenz ist dabei nur von der Spannungsdifferenz zwischen dem ersten und dem dritten Schwellwert abhängig, da diese bei gleichbleibender Kurvenform des Spannungsimpulses das Zeitintervall festlegen, in dem der Spannungsanstieg erfolgt.

Wird an die Schaltungsanordnung ein Synchronisationssignal gelegt, so hat dies zwei Wirkungen. Zum einen wird bei Spannungsgleichheit von Spannungsimpuls und drittem Schwellwert das Rücksetzen des Spannungsanstieges unterdrückt. Zum anderen erfolgt das Rücksetzen nunmehr durch die Impulsflanke des Synchronisationssignals. Die Bedeutung der Steuerung über die Impulsflanken wird später erläutert. Ein Rücksetzen des Spannungsanstieges kann somit je nach zeitlicher Lage des Synchronisationsimpulses vor oder nach Erreichen des dritten, die Nennfrequenz des Generators bestimmenden Schwellwertes ausgelöst werden. Damit können mit Hilfe dieses Verfahrens niedrigere und höhere Synchronisationsfrequenzen als die Nennfrequenz verarbeitet werden.

In der Praxis führt dies zu erheblichen Vorteilen. So ist es möglich, die Nennfrequenz des Generators genau auf den Wert der bekannten Synchronisationsfrequenz einzustellen. Der beim Übergang zwischen freilaufendem und Synchronisationsbetrieb auftretende Frequenzunterschied zwischen Nenn- und Synchronisationsfrequenz kann unter günstigen Bedingungen somit auf einen Wert nahe Null verringert werden. Folglich ist auch der beim Übergang erforderliche Schaltstrom zum Ausgleich der Regelabweichung klein. Das Schaltnetzteil arbeitet dadurch sehr zuverlässig und kann hinsichtlich seiner maximalen Strombelastung bei vorgegebener Nennleistung kleiner dimensioniert werden.

Die Vorteile der Erfindung werden besonders deutlich beim Vergleich mit der bekannten Schaltung unter ungünstigen Betriebsbedingungen, wenn z.B. die Nennfrequenz infolge von Temperatureinfluß oder Alterung um einen Wert ± d driftet. Beim Stand der Technik ist es für einen zuverlässigen Betrieb des Generators erforderlich, den Frequenzabstand zwischen Nenn- und Synchronisationsfrequenz auf einen Wert größer als die maximal zu erwartende Drift und damit mindestens auf den Wert d einzustellen. Im ungünstigsten Fall beträgt dann der beim Wechsel der Betriebszustände zu überwindende Frequenzunterschied 2d. Demgegenüber reduziert sich beim Verfahren nach der Erfindung der Frequenzunterschied um die Hälfte auf die tatsächliche Drift d.

Bislang wurde das Überführen des Generators aus dem freilaufenden Betrieb in den Synchronisationsbetrieb beschrieben. Auch der umgekehrte Fall hat praktische Bedeutung und geschieht dann, wenn das Synchronisationssignal für eine bestimmte Zeit ausbleibt. Dann erfolgt der Spannungsanstieg solange, bis der zweite, höhere Schwellwert erreicht wird und bei diesem das Rücksetzen des Spannungsanstieges veranlaßt wird. Gleichzeitig wird der dritte Schwellwert wieder wirksam geschaltet und der Impulsgenerator schwingt im freilaufenden Betrieb auf seiner Nennfrequenz. Auch hier wirkt sich beim Übergang zwischen den beiden Betriebszuständen der durch die Erfindung verkleinerte Frequenzunterschied vorteilhaft aus.

Da zum Rücksetzen des Spannungsanstieges in dem Synchronisationssignal auftretende Impulsflanken ausgenutzt werden, wird erreicht, daß ein statischer Spannungspegel am Synchronisationseingang des Generators keine Wirkung auf seinen Betriebszustand hat. Dies zeigt insbesondere Vorteile beim Einschalten des Netzteils, wenn das Synchronisationssignal noch keine ausreichend hohen Spannungswerte aufweist oder sogar statisches Nullpotential besitzt. Nach dem erfindungsgemäßen Verfahren schwingt der Generator dennoch mit seiner Nennfrequenz an,und das Schaltnetzteil versorgt die Synchronisationssignale erzeugende Schaltung mit Betriebsspannung. Bei Vorliegen definierter Impulsflanken des Synchronisationssignals wird der Generator aus dem freilaufenden Betrieb in den Synchronisationsbetrieb überführt. Auch bei Ausfall von Synchronisationsimpulsen, z. B. infolge eines Fehlers der Synchronisationssignale erzeugenden Schaltung, darf das Synchronisationssignal einen beliebigen statischen Spannungswert annehmen, wobei der Impulsgenerator weiterhin betriebsfähig bleibt.

Eine Weiterbildung des Verfahrens zeichnet sich dadurch aus, daß der Synchronisationsimpuls jeweils dann wirksam geschaltet wird, wenn der Spannungsanstieg einen vierten, zwischen dem ersten und dritten liegenden Schwellwert durchläuft. Wie bereits beschrieben, wird im Synchronisationsbetrieb das Rücksetzen des Spannungsanstieges durch einen Synchronisationsimpuls ausgelöst. Durch die Weiterbildung wird erreicht, daß dies erst dann geschehen kann, wenn der Spannungsanstieg den vierten Schwellwert überschritten hat. Im Zeitintervall, das der Spannungsanstieg für das Durchlaufen des ersten bis zum vierten Schwellwert benötigt, wird der Synchronisationsimpuls unterdrückt. Dieses Zeitintervall, das der Differenz der Spannungspegel des vierten und ersten Schwellwertes proportional ist, definiert eine obere Grenzfrequenz, oberhalb der ein Synchronisationsbetrieb ausgeschlossen ist. In gleicher Weise ist durch die Spannungsdifferenz zwischen dem ersten und dem zweiten Schwellwert eine untere Grenzfrequenz festgelegt. Ist das Zeitintervall zwischen zwei Synchronisationsimpulsen größer als das des Spannungsanstieges vom ersten bis zum zweiten Schwellwert, so löst letzterer, wie bereits beschrieben, das Rücksetzen des Spannungsanstieges aus und schaltet gleichzeitig auf freilaufenden Betrieb um. Der Synchronisationsbetrieb ist damit auf einen schmalen Frequenzbereich begrenzt, welcher die Nennfrequenz des Generators enthält. Dies wirkt sich insofern vorteilhaft aus, als auch der maximale Frequenzunterschied beim Übergang vom freilaufenden Betrieb in den Synchronisationsbetrieb selbst bei sehr ungünstigen Betriebsbedingungen auf einen vorgegebenen Wert begrenzt ist. Fällt z. B. aufgrund eines Fehlers das Synchronisationssignal auch nur vorübergehend aus oder

nimmt die Synchronisationsfrequenz kurzeitig ab, so könnte ohne diese Maßnahme bei Wiederkehr der normalen Synchronisationsfrequenz ein unzulässig hoher Frequenzunterschied mit seinen nachteiligen Folgen auftreten. Durch die Einengung des Synchronisationsbetriebs auf ein schmales Frequenzband kann dies vermieden werden.

In einer weiteren Ausgestaltung des Verfahrens ist vorgesehen, daß mindestens der erste Synchronisationsimpuls einer Synchronisationsimpulsreihe unabhängig vom Durchlaufen des vierten Schwellwertes wirksam geschaltet wird. Wenn derart vorgegangen wird, so erfolgt eine Synchronisation bereits beim ersten, in Ausnahmefällen beim zweiten Synchronisationsimpuls. Liegen beispielsweise Synchronisationsfrequenz und Nennfrequenz des Generators sehr dicht beieinander, so kann ein Synchronisationsimpuls jeweils in der Phase des Spannungs anstieges auftreten, in welcher das Synchronisationssignal unwirksam geschaltet ist. Um in diesem Fall dennoch ein Einrasten des Impulsgenerators auf die Synchronisationsfrequenz zu erzwingen, wird bereits der erste bzw. der zweite Synchronisationsimpuls wirksam geschaltet und der Spannungsanstieg zurückgesetzt. Die Spannungsimpulse am Ausgang des Impulsgenerators stimmen somit hinsichtlich Frequenz und Phase bereits nach dem ersten bzw. zweiten Synchronisationsimpuls überein.

Eine Schaltungsanordnung zur Durchführung des erfindungsgemäßen Verfahrens, mit einer bistabilen Schaltung zum Einschalten und Rücksetzen eines Spannungsanstieges, die durch das Ausgangssignal einer ersten Schwellwertschaltung in ihren einen und durch das Ausgangssignal einer zweiten Schwellwertschaltung in ihren anderen bistabilen Schaltzustand geschaltet wird, der auch durch Synchronisationsimpulse einstellbar ist, zeichnet sich dadurch aus, daß eine dritte Schwellwertschaltung vorgesehen ist, deren Ausgangssignal auf eine erste Logikschaltung geführt ist, welche die Ausgangssignale der zweiten und dritten Schwellwertschaltung sowie einer von der Impulsflanke des Synchronisationssignales angesteuerten dritten Logikschaltung konjunktiv verknüpft, und daß eine flankengesteuerte zweite Logikschaltung den Ausgang der dritten Schwellwertschaltung sperrt, wenn eine Synchronisationsimpulsfolge vorhanden ist, und ihn wieder freigibt, wenn der Spannungsanstieg den Schwellwert der zweiten Schwellwertschaltung durchläuft.

Bei dieser Schaltungsanordnung schaltet die bistabile Schaltung abhängig vom Signalzustand an ihrem Eingang den Spannungsanstieg entweder ein oder setzt ihn zurück. Ihr einer Eingang, welcher das Einschalten des Spannungsanstieges veranlaßt, wird vom Ausgang einer ersten Schwellwertschaltung angesteuert. Diese gibt dann ein Steuersignal ab, wenn beim Rücksetzen der Spannungsimpuls ihren Schwellwert unterschreitet. Der andere Eingang der bistabilen Schaltung, welcher das Rücksetzen des Spannungsanstieges bewirkt, wird über eine erste Logikschaltung angesteuert. Diese verknüpft die Ausgangssignale einer zweiten und einer dritten Schwellwertschaltung sowie einer dritten Logikschaltung so, daß ein Rücksetzen des Spannungsanstieges dann veranlaßt wird, wenn der Spannungsanstieg einen zweiten oder einen dritten Schwellwert erreicht oder wenn an der dritten Logikschaltung eine Folge von Synchronisationsimpulsen anliegt. Hierbei sind die beiden Betriebszustände freilaufender Betrieb und Synchronisationsbetrieb zu unterscheiden.

Im freilaufenden Betrieb, der durch das Fehlen von Synchronisationsimpulsen gekennzeichnet ist, ist die dritte Schwellwertschaltung wirksam. Ihr Ausgangssignal veranlaßt beim Überschreiten ihres Schwellwertes über die erste Logikschaltung sowie die bistabile Schaltung ein Rücksetzen des Spannungsanstieges. Dieses Rücksetzen erfolgt so lange, bis der Schwellwert der ersten Schwellwertschaltung unterschritten wird und dann ein neuer Impulszyklus gestartet wird. Die Amplitude des erzeugten Spannungsimpulses ist in diesem Betriebszustand durch die Spannungsdifferenz zwischen dem dritten und ersten Schwellwert bestimmt. Bei konstanter Steigung des Spannungsanstieges sind über seine Amplitude auch seine Impulsdauer bzw. Impulsfrequenz festgelegt.

Der Synchronisationsbetrieb ist gekennzeichnet durch das Auftreten einer Folge von Synchronisationsimpulsen. Eine erste Impulsflanke steuert dabei die zweite Logikschaltung so an, daß deren Ausgangssignal den Ausgang der dritten Schwellwertschaltung sperrt, und diese damit für das Rücksetzen des Spannungsanstieges unwirksam wird. Das Ausgangssignal der dritten Schwellwertschaltung wird erst dann wieder freigegeben, wenn die zweite Schwellwertschaltung einmal umschaltet. Das Synchronisationssignal ist auch der dritten Logikschaltung zugeführt. Diese erzeugt beim Auftreten einer Impulsflanke im Synchronisationssignal ein Ausgangssignal, welches mittelbar über die erste Logikschaltung das Rücksetzen des Spannungsimpulses auslöst. Wie noch beschrieben wird, ist die maximale Spannung des Spannungsimpulses durch den zweiten, oberen Schwellwert begrenzt. Dadurch kann die Spannungsamplitude beim Synchronistionsbetrieb je nach zeitlicher Lage des Synchronisationsimpulses Werte zwischen Null und der Spannungsdifferenz zwischen dem ersten und dem zweiten Schwellwert annehmen. Die Amplitude kann somit größer, aber auch kleiner als die des freilaufenden Betriebs werden.

Da die Spannungsamplitude direkt proportional der Impulsdauer und umgekehrt proportional der Frequenz des Spannungsimpulses ist, lassen sich bei der Schaltungsanordnung nach der Erfindung sowohl höhere als auch niedrigere Synchronisationsfrequenzen als die Nennfrequenz verarbeiten. Hieraus ergeben sich die bereits beschriebenen Vorteile.

Ein Übergang vom Synchronisationsbetrieb in den freilaufenden Betrieb erfolgt automatisch bei Ausbleiben von Synchronisationsimpulsen. Der Spannungsanstieg erfolgt dann ein einziges Mal bis zum zweiten, oberen Schwellwert, und die zweite Schwellwertschaltung veranlaßt das Rücksetzen des Spannungsimpulses. Gleichzeitig wird das Ausgangssignal der dritten Schwellwertschaltung wieder freigegeben, und der Spannungsanstieg verläuft zwischen dem ersten und dritten Schwellwert.

Ein weiterer wichtiger Vorteil ergibt sich dadurch, daß die zweite und dritte Logikschaltung an ihren Eingängen flankengesteuert arbeiten. Die Schaltungsanordnung wertet somit nur die im Synchronisationssignal enthaltenen Impulsflanken aus.

Dies bedeutet, daß bei Fehlen solcher Impulsflanken die Schaltungsanordnung selbsttätig den freilaufenden Betriebszustand einnimmt. Dabei dürfen an den Eingängen der zweiten und dritten Logikschaltung beliebige statische Spannungspegel anliegen. Ein unerwünschtes Anhalten des Generators durch undefinierte Synchronisationssignale ist damit ausgeschlossen.

Eine bevorzugte Ausführungsform der Schaltung zeichnet sich dadurch aus, daß eine vierte Schwellwertschaltung vorgesehen ist, deren Schwellwert zwischen dem Schwellwert der ersten und der dritten Schwellwertschaltung liegt, und deren Ausgangssignal in der dritten Logikschaltung das Durchschalten oder Sperren des Synchronisationssignales veranlaßt. Dadurch ist es möglich, das Synchronisationssignal in einem bestimmten Zeitbereich, der durch die Dauer des Spannungsanstieges zwischen den Schwellwerten der ersten und vierten Schwellwertschaltung festgelegt ist, zu unterdrücken. Ein Rücksetzen des Spannungsimpulses kann dann lediglich innerhalb des durch die Schwellwerte der vierten und zweiten Schwellwertschaltung definierten verbleibenden Zeitfensters erfolgen. Dieses entspricht im Frequenzbereich einem Bandpaß, der nur Synchronisationsimpulse innerhalb einer oberen und unteren Grenzfrequenz durchläßt. Durch Verändern der Schwellwerte, bei welchen die vierte bzw. zweite Schwellwertschaltung umschaltet, läßt sich der Frequenzabstand der unteren bzw. oberen Grenzfrequenz zur Nennfrequenz einstellen. Die Einengung der Frequenz des Synchronisationssignals hat den Vorteil, daß beim Übergang vom freilaufenden Betrieb in den Synchronisationsbetrieb auch der Frequenzunterschied innerhalb enger Grenzen liegt und damit die maximalen Schaltströme zum Ausregeln der Spannungsveränderung beim Übergang in die Betriebszustände eine vorgegebene Grenze nicht überschreiten.

Eine Weiterbildung der Schaltungsanordnung kann darin bestehen, daß die zweite Logikschaltung eine bistabile Schaltung ist, deren Takteingang das Synchronisationssignal zugeführt ist und an deren Rückstelleingang das Ausgangssignal der zweiten Schwellwertschaltung angelegt ist. Die bistabile Schaltung wird durch die Impulsflanke des Synchronisationssignales umgeschaltet und behält diesen Zustand so lange bei, bis sie durch das Ausgangssignal der zweiten Schwellwertschaltung an ihrem Rücksetzeingang in den Grundzustand zurückgesetzt wird. Die Verwendung einer bistabilen Schaltung als zweite Logikschaltung ist deshalb vorteilhaft, weil ihre Ausgangssignale somit unabhängig von der Länge des Synchronisationsimpulses sind, und dadurch die Schaltungsanordnung zuverlässig arbeitet.

Eine weitere Ausführungsform der Schaltungsanordnung kann so aufgebaut sein, daß die dritte Logikschaltung eine bistabile Schaltung ist, an deren Takteingang das Synchronisationssignal anliegt und die vom Ausgangssignal der vierten Schwellwertschaltung rückgesetzt wird. Durch diese Maßnahme wird erreicht, daß die Synchronisationsimpulse solange von der dritten Logikschaltung unterdrückt werden, bis der Spannungsanstieg den vierten Schwellwert überschritten hat. Die vierte Schwellwertschaltung gibt dann die dritte Logikschaltung zur Synchronisation wieder frei. Durch diese Maßnahme wird die beschriebene obere Frequenzbegrenzung realisiert.

Eine Weiterbildung der Schaltungsanordnung ist dadurch gegeben, daß eine vierte Logikschaltung vorgesehen ist, die das Ausgangssignal der vierten Schwellwertschaltung während mindestens des ersten Impulses einer Folge von Synchronisationsimpulsen unwirksam schaltet. Hierdurch wird ein Einrasten des Impulsgenerators auf die Synchronisationsfrequenz nach dem ersten, spätestens nach dem zweiten Synchronisationsimpuls erzwungen.

Dies hat Bedeutung, wenn Synchronisations- und Nennfrequenz annähernd gleich groß sind und der Synchronisationsimpuls dann auftritt, wenn sich der Spannungsanstieg zwischen dem ersten und vierten Schwellwert befindet. Wie vorher beschrieben, veranlaßt die vierte Schwellwertschaltung das Unterdrücken des Synchronisationsimpulses, und die erwünschte Synchronisation erfolgt erst nach Änderung der Phasenlage des Synchronisationsimpulses. Durch die hier betrachtete Weiterbildung wird das Ausgangssignal der vierten Schwellwertschaltung beim Auftreten eines Synchronisationsimpulses kurzzeitig gesperrt, und der Generator rastet sofort auf die Synchronisationsfrequenz ein. Danach wird das Ausgangssignal der vierten Schwellwertschaltung wieder freigegeben und damit die obere Frequenzbegrenzung wieder wirksam.

Ausführungsbeispiele der Erfindung werden im folgenden anhand der Figuren beschrieben. Es zeigen

Figur 1 eine schematische Übersicht einer Schaltungsanordnung zum Erzeugen von Spannungsimpulsen,

Figur 2 die genauere Ausführung einer Schaltungsanordnung nach Figur 1,

Figur 3 eine Darstellung der Signalzustände der Schaltungsanordnung nach Figur 2 bei unterschiedlichen Betriebszuständen und

Figur 4 eine andere Ausführung der Schaltungsanordnung nach Figur 1.

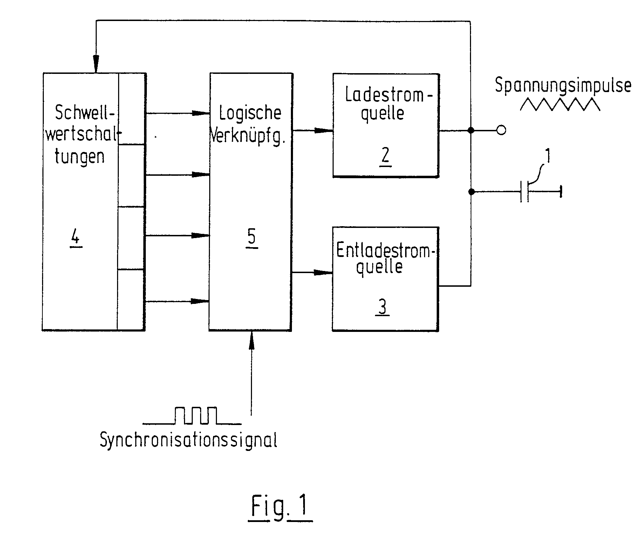

Figur 1 zeigt eine schematische Übersicht über die Schaltungsanordnung zum Erzeugen von Spannungsimpulsen. Ein Kondensator 1 wird abwechselnd von einer Ladestromquelle 2 geladen und von einer Entladestromquelle 3 entladen. Sind die Ströme konstant, so sind die Spannungsanstiege bzw. -abfälle linear. Am Kondensator 1 werden die Spannungsimpulse, in diesem Beispiel Dreiecksimpulse, abgegriffen. Dieses Ausgangssignal wird auf am Eingang der Schaltungsanordnung befindliche Schwellwertschaltungen 4 zurückgeführt. Diese vergleichen den jeweils anliegenden, zeitveränderlichen Spannungswert mit einem Schwellwert, der intern aus einer statischen Referenzspannung abgeleitet wird. Überschreitet die angelegte Spannung einen solchen Schwellwert, so schaltet die jeweilige Schwellwertschaltung ihr Ausgangssignal um, z.B. von einem positiven Spannungspegel in einen negativen. Die Ausgangssignale der Schwellwertschaltungen werden in einer logischen Verknüpfung 5 mit einem Synchronisationssignal verknüpft und daraus zwei Signale zum Steuern der Ladestrom- bzw. Entladestromquelle 2 bzw. 3 gewonnen. Zum Ansteuern der digitalen Bauelemente gelten die folgenden Pegelvereinbarungen: Ein positiver Spannungspegel entspricht dem Binärwert 1; Massepotential oder ein negativer Spannungspegel entspricht dem Binärwert 0.

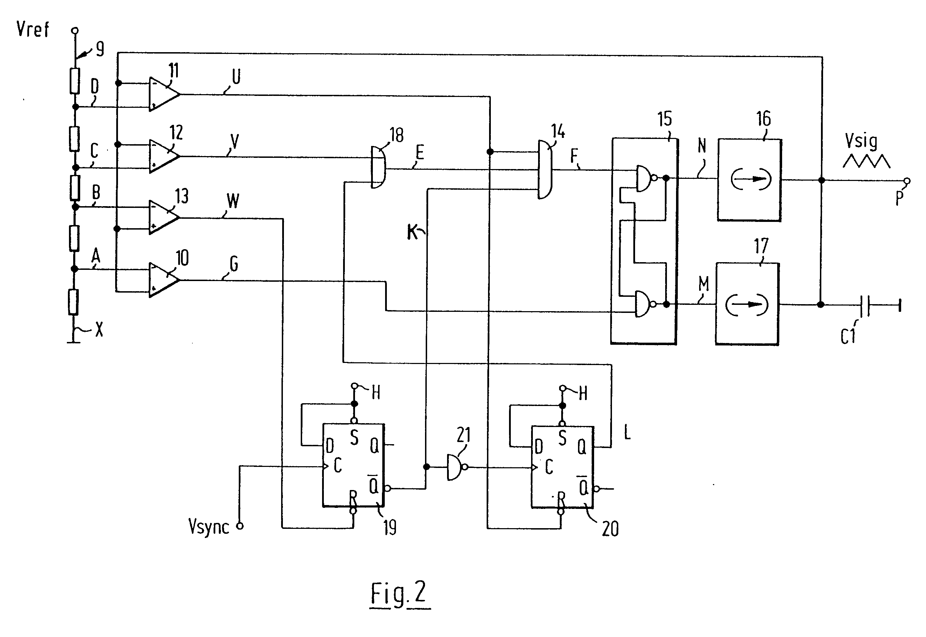

Eine genauere Ausführung der Schaltung nach Figur 1 ist in Figur 2 dargestellt. Eine Referenzspannungsquelle mit der Referenzspannung Vref speist einen Spannungsteiler 9, der einen Schwellwert A, einen Schwellwert B, einen Schwellwert C und einen Schwellwert D erzeugt. Der Schwellwert A ist an den invertierenden Eingang einer Schwellwertschaltung 10 gelegt, deren nicht invertierendem Eingang die Spannungswerte eines Ausgangssignals $V_{sig}$ zugeführt sind. Der Ausgang G der Schwellwertschaltung 10 ist mit einem Eingang einer bistabilen Schaltung 15 verbunden. Der Schwellwert B ist dem invertierenden Eingang einer Schwellwertschaltung 13 zugeführt, die an ihrem nicht invertierenden Eingang mit dem Ausgangssignal $V_{sig}$ verbunden ist. An ihrem Ausgang W ist die Schwellwert schaltung 13 mit dem Rücksetzeingang einer bistabilen Schaltung 19 verbunden. Einer Schwellwertschaltung 12 ist an ihrem nicht invertierenden Eingang der Schwellwert C, an ihrem invertierenden Eingang das Ausgangssignal $V_{sig}$ zugeführt. Sie ist ausgangsseitig an den einen Eingang eines ODER-Gliedes 18 gelegt. Eine Schwellwertschaltung 11 liegt mit ihrem nicht invertierenden Eingang an dem Schwellwert D und mit ihrem invertierenden Eingang am Ausgangssignal $V_{sig}$. Ihr Ausgangssignal U ist mit dem Rücksetzeingang einer zweiten bistabilen Schaltung 20 sowie mit einem Eingang eines UND-Gliedes 14 verbunden. Dessen zweiter Eingang ist an den Ausgang E des ODER-Gliedes 18 gelegt. Ein dritter Eingang wird vom invertierenden Ausgang K der bistabilen Schaltung 19 angesteuert. Der Ausgang F des UND-Gliedes 14 führt an den anderen Eingang der bistabilen Schaltung 15, diese steuert mit ihrem einen Ausgang N eine Entladestromquelle 16 und mit ihrem anderen Ausgang M eine Ladestromquelle 17. Deren Ströme werden einem Kondensator C1 zugeführt, an dessen Klemme P das Ausgangssignal $V_{sig}$ abgegriffen wird. Synchronisationsimpulse $V_{sync}$ werden dem Takteingang der bistabilen Schaltung 19 zugeführt. Ihr Ausgangssignal K steuert die bistabile Schaltung 20 über einen Inverter 21 an. Das Ausgangssignal L der bistabilen Schaltung 20 wird dem zweiten Eingang des ODER-Gliedes 18 zugeführt. Die bistabilen Schaltungen 19 und 20 sind an ihren S- und D-Eingängen auf positive Spannung H gelegt.

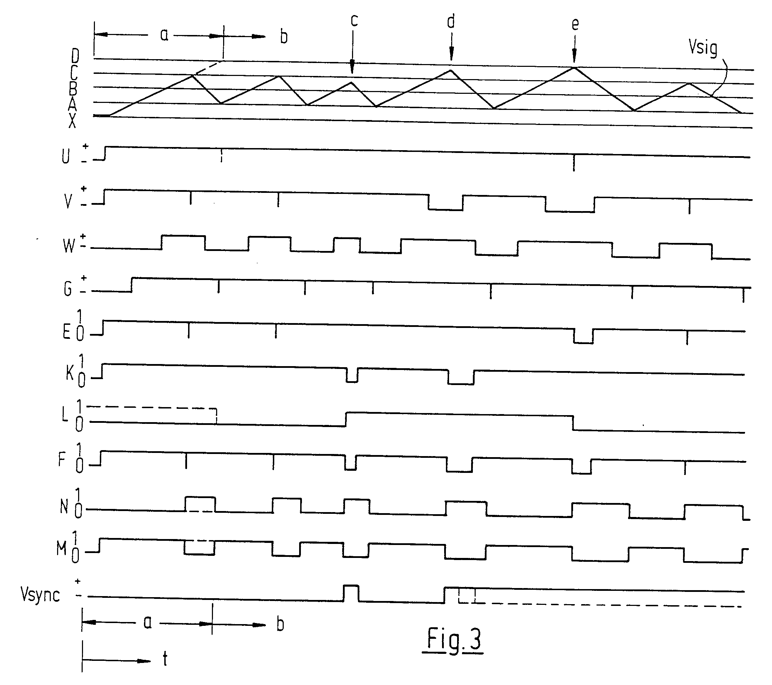

In Figur 3 sind die Signalezustände über der Zeit t dargestellt, welche die Schaltungsanordnung nach Figur 2 in den verschiedenen Betriebszuständen annehmen kann. Dem logischen Signalpegel 1 entspricht hierbei eine positive Spannung. Die Bezeichnungen für die Signale stimmen in den Figuren 2 und 3 überein. Das Ausgangssignal $V_{sig}$ hat eine Amplitude zwischen dem Spannungswert X (Masse) und dem Schwellwert D. Am Zeit verlauf des Ausgangssignals sind fünf verschiedene Betriebszustände definiert. Der Anlaufbetrieb a liegt nach dem Einschalten der Versorgungsspannung vor. Der Impulsgenerator geht dann in den freilaufenden Betrieb b über, wobei keine Synchronisationsimpulse $V_{sync}$ vorhanden sind. Weiterhin ist ein Synchronisationsbetrieb c dargestellt, der mit Synchronisationsimpulsen höherer Frequenz als die Nennfrequenz des Generators arbeitet. Ferner werden die Signalzustände bei Synchronisationsbetrieb d mit niedrigerer Frequenz als die Nennfrequenz gezeigt. Abschließend werden die Signalverläufe beim Rückkehren in den freilaufenden Betrieb beginnend mit e bei Ausbleiben von Synchronisationsimpulsen dargestellt.

Im folgenden wird die Wirkungsweise der Schaltungsanordnung nach Figur 2 beschrieben. Die den verschiedenen Betriebszuständen zugehörigen Signalzustände sind der Figur 3 zu entnehmen. Zunächst soll auf den Betrieb als freilaufender Impulsgenerator eingegangen werden. Voraussetzungsgemäß sind hierzu keine Synchronisationsimpulse $V_{sync}$ vorhanden.

Kurz nach dem Einschalten (Betriebszustand a in Figur 3) ist das Ausgangssignal $V_{sig}$ annähernd Null, und die Schwellwertschaltung 10 erzeugt an ihrem Ausgang G ein negatives Signal. Dadurch wird die bistabile Schaltung 15 so angesteuert, daß an ihrem Ausgang M das Binärsignal 1 entsteht und die Stromquelle 17 eingeschaltet wird. Sie lädt den Kondensator C1 mit konstantem Strom, so daß an der Ausgangsklemme P die Ausgangsspannung linear ansteigt. Durchläuft der Spannungsanstieg den Schwellwert C, so schaltet die Schwellwertschaltung 12 auf negatives Ausgangssignal V um, und am Ausgang E des ODER-Gliedes 18 erscheint ein 0-Signal, vorausgesetzt, die zweite bistabile Schaltung 20 führt an ihrem Ausgang L ebenfalls ein 0-Signal. Damit wird der Ausgang F des UND-Gliedes 14 auf den logischen Pegel 0 gesetzt, und die bista bile Schaltung 15 erzeugt an ihrem Ausgang N das Binärsignal 1. Die Entladestromquelle 16 wird eingeschaltet,und damit der Spannungsanstieg am Kondensator C1 rückgesetzt. Die Entladestromquelle 16 bleibt so lange eingeschaltet, bis das Ausgangssignal $V_{sig}$ den Schwellwert A durchläuft, wobei ein negatives Ausgangssignal G der Schwellwertschaltung 10 einen neuen Impulszyklus startet.

Beim Einschalten der Stromversorgung ist der logische Zustand der bistabilen Schaltung 20 an ihrem Ausgang L nicht definiert. Er kann sowohl den logischen Wert 1 als auch 0 annehmen. Sollte sich der Ausgang L, wie in Figur 3a gestrichelt eingezeichnet, im logischen Zustand 1 befinden, so würde auch am Ausgang E des ODER-Gliedes 18 der logische Zustand 1 erzeugt werden. Die den Spannungsanstieg rücksetzende Wirkung der Schwellwertschaltung 12 beim Umschalten auf negatives Ausgangssignal V wäre somit außer Kraft gesetzt. In diesem Fall steigt die Spannung bis zum Schwellwert D an, und beim Umschalten der Schwellwertschaltung 11 auf ein negatives Ausgangssignal U wird das Rücksetzen des Spannungsanstieges ausgelöst. Gleichzeitig wird die bistabile Schaltung 20 in ihren Grundzustand rückgesetzt, wobei ihr Ausgangssignal L als Binärwert 0 erscheint. Der Impulsgenerator wird somit in den sicheren freilaufenden Betriebszustand, wie in Figur 3b dargestellt, geführt. Auch ein undefinierter Zustand der bistabilen Schaltung 19 mit ihrem Ausgangssignal K könnte nach dem Einschalten ein unerwünschtes Rücksetzen des Spannungsanstieges über das UND-Glied 14 bewirken. Jedoch wird nach Start des Spannungsanstieges und Durchlaufen des Schwellwertes B das Ausgangssignal K der bistabilen Schaltung 19 über die Schwellwertschaltung 13 definiert auf den logischen Zustand 1 gesetzt. Damit ist ein sicheres Anschwingen des Impulsgenerators gewährleistet.

Der Synchronisationsbetrieb beginnt, wenn eine positive Flanke eines Synchronisationssignals $V_{sync}$ am Takteingang der bistabilen Schaltung 19 anliegt. Es wird zunächst angenommen, daß sich der Spannungsanstieg zwischen den Schwellwerten B und C befindet (Betriebszustand c in Figur 3). Dann ist das Ausgangssignal W der Schwellwertschaltung 13 positiv und die bistabile Schaltung 19 wird durch die Impulsflanke an ihrem Ausgang K in den logischen Zustand 0 umgeschaltet. Damit wird der Logikpegel am Ausgang F des UND-Gliedes 14 zu 0 und über die bistabile Schaltung 15 das Rücksetzen des Spannungsanstieges ausgelöst. Gleichzeitig wird auch die bistabile Schaltung 20 an ihrem Ausgang L über den Inverter 21 in den logischen 1-Zustand gesetzt. Am Ausgang E des ODER-Gliedes 18 erscheint eine logische 1, unabhängig vom Ausgangspegel der Schwellwertschaltung 12. Dieser Zustand bleibt so lange erhalten, bis der Spannungsanstieg einmal den Schwellwert D überschreitet und die bistabile Schaltung 20 über die Schwellwertschaltung 11 rückgesetzt wird. Erreicht ein Synchronisationsimpuls $V_{sync}$, wie in Figur 3d gestrichelt dargestellt, die Schaltungsanordnung während des Rücksetzvorganges, so ändert dies nichts an der grundsätzlichen Wirkungsweise. Im Synchronisationsbetrieb ist somit die maximale Amplitude des Spannungsimpulses durch die Differenz der Schwellwerte D und A festgelegt.

Es soll nunmehr die Wirkungsweise der Frequenzbegrenzung erläutert werden. Synchronisationsimpulse, die während des Zeitintervalls, in dem sich die Amplitude des Spannungsimpulses zwischen den Schwellwerten B und D bewegt, bewirken ein Rücksetzen des Spannungsimpulses und somit ein Einrasten des Impulsgenerators auf die Synchronisationsfrequenz. Wird die Zeit zwischen den Synchronisationsimpulsen größer als die Zeit, die der Spannungsanstieg vom Schwellwert A bis zum Schwellwert D benötigt, so schaltet die Schwellwertschaltung 11 vor dem Eintreffen eines Synchronisationsimpulses in den freilaufenden Betriebszustand zurück. Damit ist eine untere Grenzfrequenz fest vorgegeben. Eine obere Grenzfrequenz ist durch die Schwellwertschaltung 13 festgelegt. Synchronisationsimpulse, deren zeitlicher Abstand kleiner ist als das Zeitintervall, welches der Spannungsanstieg vom Schwellwert A nach B benötigt, bleiben unwirksam. Die Schwellwertschaltung 13 erzeugt an ihrem Ausgang W ein negatives Signal, das die bistabile Schaltung 19 für dieses Zeitintervall in den Grundzustand rücksetzt, so daß diese keine Synchronisationsimpulse an ihrem Ausgang durchschaltet.

Eine Rückkehr in den freilaufenden Betrieb, entsprechend dem Betriebszustand e in Figur 3, erfolgt bei Ausbleiben von Synchronisationsimpulsen $V_{sync}$. Der Spannungsanstieg $V_{sig}$ erreicht dann den oberen Schwellwert D und die Schwellwertschaltung 11 veranlaßt über ihr Ausgangssignal U ein Rücksetzen des Spannungsanstieges. Gleichzeitig wird über das Sinal U die bistabile Logikschaltung 20 in ihren Grundzustand geschaltet, wobei ihr Signal L den Logikpegel 0 annimmt. Das Ausgangssignal E des ODER-Gliedes 18 hängt somit allein vom Signal V und damit vom Schaltzustand der Schwellwertschaltung 12 ab. Erreicht der Spannungsanstieg ihren Schwellwert C, so wird über die Signale V,E,F,N der Spannungsanstieg rückgesetzt. Der Generator schwingt im freilaufenden Betrieb. Wie in Figur 3 beim Betriebszustand e dargestellt, darf der an der bistabilen Schaltung 19 anliegende statische Spannungspegel des Synchronisationssignals $V_{sync}$ sowohl positiv (ausgezogene Linie) als auch negativ (gestrichelte Linie) sein.

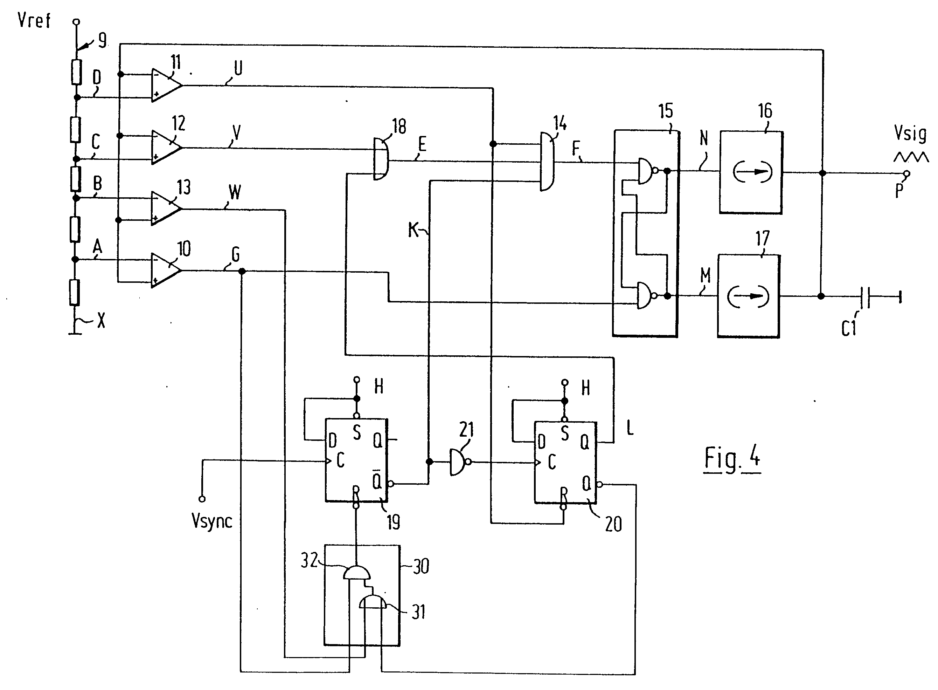

In Figur 4 ist eine Schaltungsanordnung zum schnellen Synchronisieren dargestellt, die sämtliche Bauelemente der Figur 2 enthält und lediglich um eine vierte Logikschaltung 30 erweitert ist. Diese enthält ein ODER-Glied 31 und ein UND-Glied 32. In dieser Schaltung ist der invertierende Ausgang R der zweiten bistabilen Logikschaltung 20 an den Eingang des ODER-Gliedes 31 gelegt, dessen weiterer Eingang mit dem Ausgang W der Schwellwertschaltung 13 verbunden ist. Das UND-Glied 32 ist mit seinem einen Eingang an den Ausgang des ODER-Gliedes 31 und mit seinem anderen Eingang an den Ausgang G der Schwellwertschaltung 10 angeschlossen. Der Ausgang der vierten Logikschaltung 30 führt auf den Rücksetzeingang der dritten bistabilen Schaltung 19.

Die Wirkungsweise wird anhand der Figur 4 erläutert. Bei Ausbleiben von Synchronisationsimpulsen wird der Ausgang R der bistabilen Schaltung 20 in den logischen Zustand 1 gesetzt. Das ODER-Glied 31 führt damit an seinem Ausgang ein 1-Signal unabhängig vom Signalzustand der Schwellwertschaltung 13. Das dem ODER-Glied 31 nachgeschaltete UND-Glied 32 erzeugt an seinem Ausgang dann ein logisches 1-Signal, wenn die Spannungsamplitude des Spannungsimpulses $V_{sig}$ oberhalb des Schwellwertes A liegt. Nur nach dem Rücksetzen des Spannungsanstieges, bei dem die Schwellwertschaltung 10 kurzzeitig an ihrem Ausgang negatives Potential annimmt, wird am Ausgang der vierten Logikschaltung 30 ein 0-Signal erzeugt, und die bistabile Schaltung 19 wird in ihren definierten Ausgangszustand gesetzt. Bei Eintreffen der ersten positiven Impulsflanke des Synchronisationsimpulses $V_{sync}$ wird dadurch sofort der Spannungsanstieg rückgesetzt, und der Impulsgenerator schwingt synchron. Die Synchronisation ist aufgrund der hier beschriebenen Schaltungsmaßnahmen bereits unterhalb des Schwellwertes B möglich. Nach dem ersten Synchronisationsimpuls wird die zweite bistabile Schaltung 20 an ihrem Ausgang R auf 0-Signal gesetzt, und die frequenzbegrenzende Wirkung der Schwellwertschaltung 13 ist wieder voll wirksam. Da nach dem Einschalten der Spannungsversorgung der Schaltungsanordnung das Ausgangssignal R der bistabilen Schaltung 20 zufällig den Binärwert 0 haben kann, setzt in diesem Fall eine Zwangssynchronisation erst beim zweiten Synchronisationsimpuls ein. Der Spannungsanstieg erfolgt dann bis zum Schwellwert D, und die Schwellwertschaltung 11 setzt die bistabile Schaltung 20 in einen definierten Ausgangszustand zurück.

**Ansprüche**

1. Verfahren zum Erzeugen von Spannungsimpulsen zur Steuerung des Schaltbetriebes in Schaltnetzteilen, bei dem ein jeweils von einem ersten, unteren Schwellwert ausgehender Spannungsanstieg bei Erreichen eines zweiten, höheren Schwellwertes oder bei Auftreten eines Synchronisationsignales auf den Anfangswert rückgesetzt wird, dadurch **gekennzeichnet,** daß der Spannungsanstieg bei Erreichen eines dritten (C), zwischen dem ersten (A) und dem zweiten (D) liegenden Schwellwertes rückgesetzt wird, wobei dieser Schwellwert (C) bei Fehlen eines Synchronisationssignales (Vsync) oder nach Erreichen des zweiten Schwellwertes (D) wirksam ist, und daß zum Rücksetzen des Spannungsanstieges in dem Synchronisationssignal ($V_{sync}$) auftretende Impulsflanken ausgenutzt werden.

2. Verfahren nach Anspruch 1, dadurch **gekennzeichnet,** daß der Synchronisationsimpuls jeweils dann wirksam geschaltet wird, wenn der Spannungsanstieg einen vierten (B), zwischen dem ersten (A) und dritten (C) liegenden Schwellwert durchläuft.

3. Verfahren nach Anspruch 2, dadurch **gekennzeichnet,** daß mindestens der erste Synchronisationsimpuls einer Synchronisationsimpulsreihe unabhängig vom Durchlaufen des vierten Schwellwertes (B) wirksam geschaltet wird.

4. Verfahren nach einem der Ansprüche 1 bis 3, dadurch **gekennzeichnet,** daß das Rücksetzen des Spannungsanstieges innerhalb einer einstellbaren Zeit erfolgt.

5. Schaltungsanordnung zur Durchführung des Verfahrens nach Anspruch 1, mit einer bistabilen Schaltung zum Einschalten und Rücksetzen eines Spannungsanstieges, die durch das Ausgangssignal einer ersten Schwellwertschaltung in ihren einen und durch das Ausgangssignal einer zweiten Schwellwertschaltung in ihren anderen bistabilen Schaltzustand geschaltet wird, der auch durch Synchronisationssignale einstellbar ist, dadurch **gekennzeichnet,** daß eine dritte Schwellwertschaltung (12) vorgesehen ist, deren Ausgangssignal (V) auf eine erste Logikschaltung (14) geführt ist, welche die Ausgangssignale der zweiten (11) und dritten Schwellwertschaltung (12) sowie einer von der Impulsflanke des Synchronisationssignales ($V_{sync}$) angesteuerten dritten Logikschaltung (19) konjunktiv verknüpft, und daß eine flankengesteuerte zweite Logikschaltung (20) den Aus gang (V) der dritten Schwellwertschaltung (12) sperrt, wenn eine im Synchronisationssignal ($V_{sync}$) enthaltene Impulsfolge vorhanden ist, und ihn wieder freigibt, wenn der Spannungsanstieg den Schwellwert (D) der zweiten Schwellwertschaltung (11) durchläuft.

6. Schaltungsanordnung nach Anspruch 5, dadurch **gekennzeichnet,** daß eine vierte Schwellwertschaltung (13) vorgesehen ist, deren Schwellwert (B) zwischen dem Schwellwert der ersten (10) und der dritten Schwellwertschaltung (12) liegt und deren Ausgangssignal (W) in der dritten Logikschaltung (19) das Durchschalten oder Sperren des Synchronisationssignals (Vsync) veranlaßt.

7. Schaltungsanordnung nach Anspruch 5 oder 6, dadurch **gekennzeichnet,** daß die zweite Logikschaltung (20) eine bistabile Schaltung ist, deren Takteingang das Synchronisationssignal ($V_{sync}$) zugeführt ist und an deren Rückstelleingang das Ausgangssignal (U) der zweiten Schwellwertschaltung (11) angelegt ist.

8. Schaltungsanordnung nach einem der Ansprüche 5 bis 7, dadurch **gekennzeichnet,** daß die dritte Logikschaltung (19) eine bistabile Schaltung ist, an deren Takteingang das Synchronisationssignal ($V_{sync}$) anliegt und die vom Ausgangssignal (W) der vierten Schwellwertschaltung (13) rückgesetzt wird.

9. Schaltungsanordnung nach Anspruch 8, dadurch **gekennzeichnet,** daß der Takteingang der zweiten Logikschaltung (20) mit dem Ausgang der dritten Logikschaltung (19) verbunden ist.

10. Schaltungsanordnung nach einem der Ansprüche 5 bis 9, dadurch **gekennzeichnet,** daß das Sperren und Freigeben des Ausgangssignals der dritten Schwellwertschaltung (12) durch ein ODER-Glied (18) erfolgt.

11. Schaltungsanordnung nach einem der Ansprüche 5 bis 10, dadurch **gekennzeichnet,** daß die erste Logikschaltung (14) ein UND-Glied ist.

12. Schaltungsanordnung nach einem der Ansprüche 6 bis 11, dadurch **gekennzeichnet,** daß eine vierte Logikschaltung (30) vorgesehen ist, die das Ausgangssignal (W) der vierten Schwellwertschaltung (13) während mindestens des ersten Impulses einer Folge von Synchronisationsimpulsen ($V_{sync}$) unwirksam schaltet.

13. Schaltungsanordnung nach Anspruch 12, dadurch **gekennzeichnet,** daß die vierte Logikschaltung (30) zunächst die Ausgangssignale der zweiten Logikschaltung (20) und der vierten Schwellwertschaltung (13) disjunktiv verknüpft und das entstehende Ausgangssignal konjunktiv mit dem Ausgangssignal (G) der ersten Schwellwertschaltung (10) verknüpft und dieses Signal der dritten Logikschaltung (19) zugeführt ist.

Fig. 1

Fig.2

EP 0 324 089 A2

Fig.3

Fig. 4

EP 0 324 089 A2